Europäisches Patentamt

European Patent Office

Office européen des brevets

(19)

(11) Numéro de publication : **0 228 431 B1**

(12) ## FASCICULE DE BREVET EUROPEEN

(45) Date de publication du fascicule du brevet :
**26.06.91 Bulletin 91/26**

(51) Int. Cl.$^5$ : **H01L 23/28**

(21) Numéro de dépôt : **86904204.4**

(22) Date de dépôt : **01.07.86**

(86) Numéro de dépôt international :
**PCT/FR86/00232**

(87) Numéro de publication internationale :
**WO 87/00689 29.01.87 Gazette 87/03**

(54) **DISPOSITIF DE DURCISSEMENT, PAR INSERTS, D'UN COMPOSANT ELECTRONIQUE VIS-A-VIS DE RADIATIONS.**

(30) Priorité : **12.07.85 FR 8510721**

(43) Date de publication de la demande :
**15.07.87 Bulletin 87/29**

(45) Mention de la délivrance du brevet :
**26.06.91 Bulletin 91/26**

(84) Etats contractants désignés :
**DE GB IT NL SE**

(56) Documents cités :
**EP-A- 0 128 079**
**US-A-31 482 80**

(73) Titulaire : **THOMSON-CSF**
**173, boulevard Haussmann**
**F-75379 Paris Cedex 08 (FR)**

(72) Inventeur : **VAL, Christian**
**81, rue de Paris**
**F-78470 St. Rémy les Chevreuses (FR)**

(74) Mandataire : **Benoit, Monique et al**
**THOMSON-CSF SCPI**
**F-92045 PARIS LA DEFENSE CEDEX 67 (FR)**

## Description

La présente invention a pour objet un dispositif réalisant le durcissement d'un composant électronique, c'est-à-dire la protection de ce dernier contre des radiations, notamment des radiations ionisantes.

Dans la description suivante, on désignera, pour simplifier, par "composant" tout composant discret ou tout ensemble de composants formant un circuit hybride ou intégré.

La réalisation d'équipements électroniques performants, tant sur le plan de la vitesse de traitement que de la compacité ou de la capacité, tels que des calculateurs embarqués, nécessite des circuits complexes, rapides et à haut degré d'intégration. Or ces circuits sont très sensibles aux effets des radiations en général, et plus particulièrement ceux qui résultent de l'ionisation.

Pour limiter ces effets, différentes techniques de protection ou de "durcissement" sont connues.

L'une de ces techniques consiste à réaliser un blindage extérieur de l'équipement électronique complet, à l'aide par exemple de feuilles d'un métal choisi en fonction du type de radiations à arrêter. Ses inconvénients sont principalement le poids et l'encombrement, particulièrement gênants pour des matériels embarqués.

Selon une autre technique on choisit, pour réaliser l'équipement, des composants et/ou des circuits résistant aux radiations de par leur structure même : le durcissement est le résultat à la fois des règles de conception utilisées (prenant notamment en compte la variation de certains paramètres et les dégradations provoquées par les radiations) et des technologies choisies. De tels composants ou circuits existent à l'heure actuelle mais en petit nombre et ils ne sont pas assez performants pour certaines applications, notamment sur le plan des degrés d'intégration atteints ; en outre, leur réalisation en technologie durcie exige parfois des délais longs et leur coût est élevé.

Une autre technique, connue du document EP-A-0 128 079, consiste à placer dans un boîtier spécial, réalisé pour résister aux radiations. Une (ou plusieurs) paroi de ce boîtier est constituée par une pluralité de couches de matériaux dont les nombres de charges atomiques (généralement notés Z) varient d'une valeur élevée à une valeur plus faible ; les couches à valeur Z élevée ont pour fonction d'arrêter les rayonnements, principalement ionisants, et les couches à valeur Z faible, de limiter le flux d'électrons secondaires produits dans les couches précédentes. Toutefois, lorsque le flux de radiations devient élevé, il se produit une importante élévation de température dans le matériau à nombre Z élevé, conduisant à un choc thermique à l'interface des matériaux nombre Z élevé-nombre Z faible qui peut amener la destruction de la structure.

La présente invention a pour objet un dispositif de durcissement comportant au mois deux matériaux, l'un des matériaux ayant un nombre de charges atomiques Z élevé par rapport à celui de l'autre ; l'un de ces matériaux se présente sous la forme d'inserts placés dans une couche formée par l'autre matériau. Le dispositif de durcissement est alors réalisé par un empilement de telles couches, la densité des inserts variant d'une couche à l'autre, faisant ainsi varier de façon progressive le nombre de charges résultant du dispositif de durcissement tout le long de son épaisseur, selon une loi prédéfinie.

Plus précisément, l'invention a pour objet un dispositif de durcissement tel que défini par la revendication 1.

Le dispositif de durcissement ainsi réalisé peut soit être placé sur le composant ou sur le boîtier d'encapsulation du composant, soit encore former tout ou partie du boîtier lui-même.

De la sorte, les deux premières limitations mentionnées ci-dessus pour les dispositifs connus sont évités, et la progressivité de la variation du nombre Z évite les chocs thermiques à l'interface.

D'autres objets, particularités et résultats de l'invention ressortiront de la description suivante, illustrée par les dessins annexés qui représentent :

- la figure 1, une vue en coupe schématique du dispositif de durcissement selon l'invention ;
- la figure 2, un mode de réalisation d'une couche formant le dispositif selon l'invention ;
- la figure 3, une variante de mise en oeuvre du dispositif selon l'invention ;
- la figure 4, une application du dispositif selon l'invention à la réalisation d'un condensateur ;
- la figure 5, l'application du dispositif de durcissement selon l'invention à la protection directe d'un composant ;
- la figure 6, l'utilisation du dispositif de durcissement selon l'invention pour la formation d'un boîtier encapsulant un composant ;
- la figure 7, l'application du dispositif de durcissement selon l'invention sur un boîtier encapsulant un composant.

Sur ces différentes figures, d'une part l'échelle réelle n'a pas été respectée à des fins de clarté et, d'autre part, les mêmes références se rapportent aux mêmes éléments.

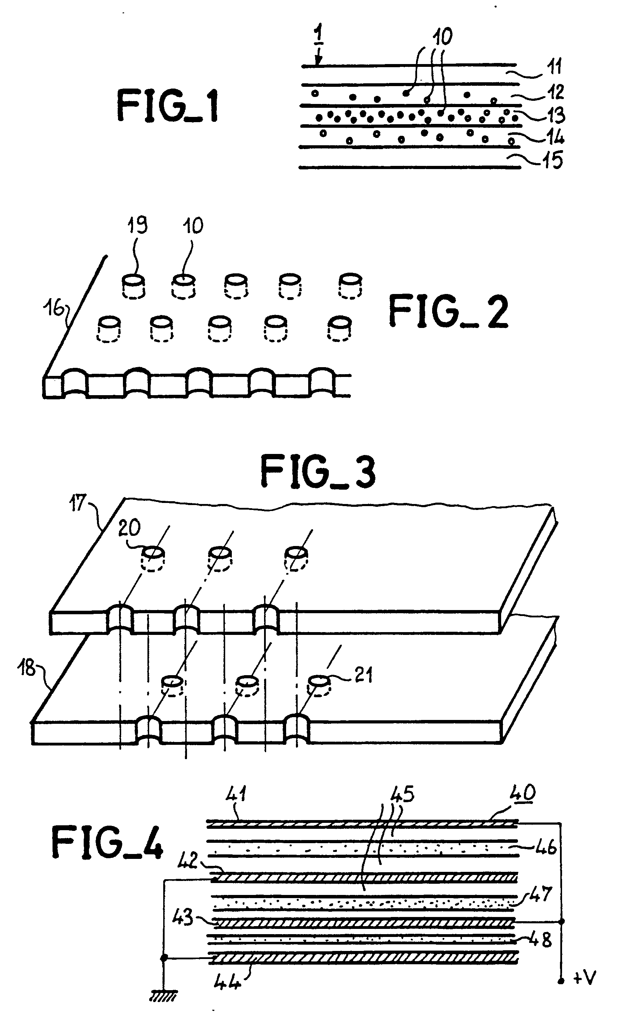

La figure 1 représente donc, vu en coupe, un mode de réalisation du dispositif de durcissement selon l'invention.

Ce dispositif, globalement repéré 1, est constitué par un empilement de plusieurs couches, ou feuilles, cinq couches dans l'exemple de la figure, repérées 11 à 15. La première couche (11) est par exemple réalisée en un premier matériau, à nombre de charges atomiques $Z_1$ faible. La seconde couche (12) est par exemple réalisée à l'aide du même matériau, mais dans lequel ont été placés des inserts (10) d'un second matériau, ce second matériau étant caractérisé par un nombre de charges atomiques $Z_2$ élevé ; de la sorte, le nombre de charges atomiques $Z_{12}$ résultant pour la couche 12 est plus élevé que celui ($Z_1$) de la couche 11. La troisième couche (13) est réalisée de façon analogue à la couche 12 mais avec une densité d'inserts supérieure, de sorte que le nombre de charges résultant $Z_{13}$ pour la couche 13 soit supérieur au nombre $Z_{12}$. La quatrième couche (14) est réalisée comme la couche 12 et avec sensiblement la même densité d'inserts, conduisant à un nombre de charge résultant $Z_{14}$ sensiblement identique au nombre $Z_{12}$. Enfin, la dernière couche (15) ne comporte pas d'insert et elle est réalisée à l'aide du même matériau que la couche 11, conduisant au même nombre ($Z_1$) de charges.

Il apparaît ainsi que le nombre de charges atomiques du dispositif 1, dans cet exemple, est croissant de la première couche (11) vers le milieu (couche 13) et décroissant ensuite, selon une loi de variation symétrique. Cette loi est bien entendu fonction du nombre de couches, de leur densité d'inserts respective et des matériaux choisis pour réaliser les couches et leurs inserts.

Le fonctionnement d'un tel dispositif est le suivant : ainsi qu'il est connu, les matériaux à nombre de charges élevé permettent d'atténuer notamment les rayonnements fortement ionisants, tels que les rayons X et gamma. Toutefois cette atténuation entraîne la production d'un flux d'électrons secondaires qu'il est souhaitable également d'atténuer autant que possible, ce flux d'électrons étant en effet susceptible de perturber le fonctionnement du composant électronique à protéger. Pour remplir cette dernière fonction, un matériau à nombre de charges plus faible est préférable : il est en effet suffisant sur le plan énergétique, plus léger, répondant ainsi au critère de poids énoncé plus haut, et faiblement émissif d'électrons. La zone à nombre de charges faible doit donc être placée de préférence en vis-à-vis du composant électronique à protéger. Dans le mode de réalisation représenté figure 1, où la structure est symétrique, il est prévu une couche à nombre de charges faible également de l'autre côté du dispositif, afin de limiter l'émission d'électrons vers le reste de l'équipement électronique.

En ce qui concerne le choix des matériaux constituant le dispositif 1, on entend dans la présente description par nombre de charges élevé, un nombre au moins égal à 35 et par nombre de charges faible, un nombre au plus égal à 20. Le matériau à nombre de charges faible peut être par exemple un des corps suivants : carbone, aluminium, silicium, alumine ou silice. Le matériau à nombre de charges élevé peut être du platine ou une céramique diélectrique, choisie soit dans la famille des titanates, par exemple titanate de baryum modifié (avec des métaux lourds) ou titanate de strontium avec oxyde de néodyne (également modifié), soit dans la famille des oxydes, par exemple l'oxyde de titane (modifié également), soit encore une céramique complexe à base de plomb. Le matériau formant la couche dans laquelle sont placés les inserts ainsi que le matériau qui constitue les inserts peuvent varier d'une couche à l'autre ; toutefois, pour des raisons d'adaptation mécanique et thermique, il est en général préférable de conserver les mêmes matériaux d'une couche à la suivante.

Les inserts de matériau à nombre Z élevé peuvent être dispersés dans la couche de façon aléatoire ou répartis de façon prédéfinie, non aléatoire.

Dans le premier mode de réalisation, aléatoire, on peut par exemple mélanger des billes ou des grains de forme quelconque, destinés à constituer les inserts à nombre Z élevé, dans une barbotine constituée d'un matériau à nombre Z faible, puis à couler ce matériau sous forme de feuilles pour lui permettre de constituer l'une des couches 12 à 14 de la figure 1. Les différentes feuilles sont ensuite frittées ensemble afin d'obtenir un dispositif solide. Chacune des feuilles est optiquement étanche à condition que la densité d'inserts et l'épaisseur de la feuille soit suffisantes.

Le deuxième mode de réalisation, dans lequel les inserts sont disposés de façon prédéfinie, est représenté figure 2.

Sur la figure 2, on voit, vue en coupe, une feuille 16 susceptible de remplir la fonction de l'une des couches 12 à 14 de la figure 1. Dans cette feuille 16, on a pratiqué des trous 19 régulièrement espacés, par exemple sous forme de matrice rectangulaire. La forme des trous est par exemple cylindrique à base circulaire, comme représenté sur la figure 2, ou sensiblement rectangulaire, par exemple traversant la couche 16 de part en part.

Dans ces trous 19 sont placés des inserts 10 d'un matériau à nombre de charges plus élevé que celui de la couche 16, comme illustré sur la figure 1.

Afin de rendre une telle structure optiquement étanche, il est préférable de disposer pour chacune des densités souhaitées deux couches telles que la couche 16, comme montré sur la figure 3, ou davantage.

Sur la figure 3 on a représenté, également vues en coupe, deux couches repérées respectivement 17 et 18, analogues à la couche 16. Chacune de ces couches comporte des trous repérés respectivement 20 et 21, analogues aux trous 19 de la figure 2 et destinés à être rempli d'un matériau à nombre de charges élevé, formant l'insert. Les couches 17 et 18 peuvent être avantageusement identiques, pour des raisons de simplicité de fabrication.

Toutefois, les couches sont disposées l'une par rapport à l'autre de telle sorte que les trous 21 viennent se placer entre les trous 20, de façon à rendre le dispositif optiquement étanche. Selon le pas retenu pour les trous et la taille de ceux-ci, il peut être nécessaire de disposer plus de deux couches pour obtenir un dispositif optiquement étanche.

La figure 4 représente, vu en coupe, un mode de réalisation du dispositif de durcissement selon l'invention dans lequel celui-ci forme un condensateur multicouche.

Ce condensateur, repéré globalement 40, comporte à titre d'exemple quatre électrodes, repérées 41 à 44, deux d'entre elles (41 et 43) étant reliées à un potentiel + V et les deux autres (42 et 44) à la masse. Entre ces électrodes, on a disposé des couches analogues aux couches 11 à 15 de la figure 1, dont la densité d'inserts est variable afin de réaliser la variation recherchée du nombre de charges Z du condensateur dans son épaisseur ; à titre d'exemple, la loi retenue ici est une variation symétrique autour d'une valeur maximale centrale. A cet effet, le dispositif comporte trois sandwichs ; chacun des sandwichs est constitué par une couche centrale comportant des inserts (couches 46, 47 et 48 respectivement) entourée de part et d'autre par une couche (45) d'un matériau à faible nombre Z sans insert ; les couches extérieures (45) de chaque sandwich sont en contact avec les électrodes (41-44). Le sandwich central (successivement couches 45, 47, 45) est celui qui présente le nombre Z le plus élevé.

Dans cette application à la constitution d'un condensateur, lorsque les inserts sont réalisés en un matériau conducteur de l'électricité, il est préférable (comme représenté figure 4) que soient en contact avec les électrodes des couches dépourvues d'insert, du fait qu'il existe alors un risque de court-circuit entre les électrodes.

Enfin, les inserts peuvent être disposés dans les couches 46, 47, 48 de façon aléatoire ou non, comme décrit ci-dessus.

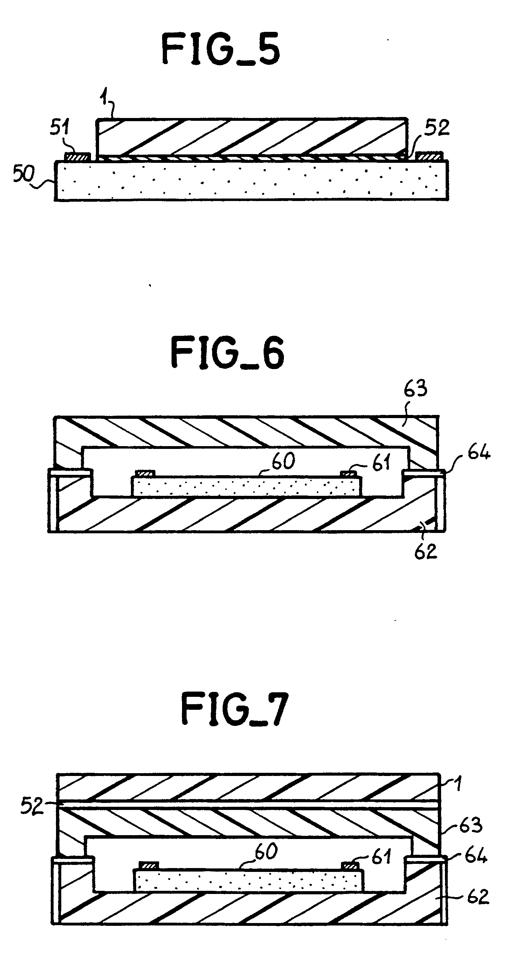

La figure 5 représente, vu en coupe, un mode d'application du dispositif de durcissement selon l'invention à la protection directe d'un composant électronique.

Sur cette figure, on a représenté schématiquement un composant électronique 50, sur la surface supérieure duquel deux plots de connexion 51 sont visibles. Le dispositif de durcissement selon l'invention et tel que décrit ci-dessus figures 1 à 4, est placé directement sur la surface supérieure du composant 50, par l'intermédiaire éventuellement d'un matériau de fixation 52, par exemple une colle souple.

Un autre dispositif de durcissement peut bien entendu être disposé sur la face inférieure du composant. Toutefois, celui-ci est en général disposé dans un boîtier où sur un circuit imprimé ou hybride, comportant éventuellement un drain thermique, l'ensemble constituant déjà une protection contre les radiations.

La figure 6 représente, vu en coupe, un mode d'application du dispositif de durcissement selon l'invention à la réalisation d'un boîtier pour composant électronique.

Sur cette dernière figure, on a représenté un composant électronique 60 muni de plots de connexion 61 et fixé sur l'embase 62 d'un boîtier dont le capot est repéré 63 ; le capot est fixé sur l'embase 62 par un joint 64. Le boîtier est par exemple du type "CHIP CARRIER".

Selon l'invention, tout ou partie du boîtier 62, 63 est réalisé, comme décrit ci-dessus, par un empilement de couches comportant une densité d'inserts variable, formant éventuellement condensateur.

La figure 7 représente, vu en coupe, un mode d'application du dispositif de durcissement selon l'invention à la protection d'un composant électronique placé dans un boîtier.

Sur la figure 7, on retrouve le composant 60 encapsulé dans le boîtier 62-63.

Dans ce mode de réalisation sur une (ou plusieurs) des parois libres du boîtier est placé un (ou plusieurs) dispositif de durcissement selon l'invention. Cette (ou ces) paroi libre peut être une paroi intérieure ou extérieure de l'embase 62 ou du capot 63. Dans l'exemple de la figure 7, on a disposé un dispositif de durcissement, repéré 1, sur la paroi supérieure (extérieure) du capot 63. Le dispositif 1 est par exemple fixé par l'intermédiaire du matériau de fixation 52.

La description ci-dessus a bien entendu été faite à titre d'exemple non limitatif. C'est ainsi par exemple que les inserts ont été décrits comme ayant un nombre de charges élevé alors que la couche dans laquelle ils sont placés est à nombre de charges faible ; il est possible de procéder de façon inverse, avec des inserts à nombre de charges faible dans une couche à nombre de charges élevé ; dans ce cas, ce sont les couches à densité d'inserts élevée qui devront être du côté du composant.

## Revendications

1. Dispositif de durcissement d'un composant électronique (50) vis-à-vis des radiations, comportant une pluralité de couches (11-15 ; 16 ; 17, 18 ; 46-48), le nombre de charges atomiques résultant du dispositif variant le long de son épaisseur, le dispositif étant caractérisé en ce que certaines au moins des couches comportent au moins deux matériaux, l'un d'eux ayant un nombre de charges atomiques élevé par rapport à celui de l'autre, que l'un de ces matériaux se présente sous la forme d'inserts (10) placés dans la couche formée par l'autre matériau, et que la densité d'inserts, sensiblement constante dans une couche, varie selon les couches.

2. Dispositif selon la revendication 1, caractérisé par le fait que la couche est formée par un matériau à faible nombre de charges et les inserts, par un matériau à nombre de charges élevé

3. Dispositif selon l'une des revendications précédentes, caractérisé par le fait que la densité d'inserts varie de sorte que le nombre de charges résultant présente un minimum du côté du composant.

4. Dispositif selon l'une des revendications précédentes, caractérisé par le fait que la variation du nombre de charges est symétrique par rapport à la zone médiane du dispositif.

5. Dispositif selon l'une des revendications précédentes, caractérisé par le fait que les inserts sont disposés dans la couche de façon aléatoire.

6. Dispositif selon la revendication 5, caractérisé par le fait que les inserts sont du type bille ou grain.

7. Dispositif selon l'une des revendications 1 à 4, caractérisé par le fait que les inserts sont disposés dans la couche (16 ; 17 ; 18) dans des trous (19, 20) pratiqués régulièrement dans la couche.

8. Dispositif selon l'une des revendications précédentes, caractérisé par le fait que le dispositif comporte en outre, entre les couches (46-48), des couches conductrices formant électrodes (41-44), ledit dispositif formant un condensateur.

9. Dispositif selon l'une des revendications précédentes, caractérisé par le fait qu'il est disposé sur une face du composant.

10. Dispositif selon l'une des revendications précédentes, caractérisé par le fait qu'il forme au moins une partie d'un boîtier (62, 63) d'encapsulation du composant.

11. Dispositif selon l'une des revendications précédentes, caractérisé par le fait qu'il est disposé sur une face d'un boîtier d'encapsulation du composant.

12. Dispositif selon l'une des revendications précédentes, caractérisé par le fait que le matériau à nombre de charges faible a un nombre de charges au plus égal à 20.

13. Dispositif selon l'une des revendications précédentes, caractérisé par le fait que le matériau à nombre de charges faible est choisi dans le groupe suivant : carbone, aluminium, silicium, alumine, silice.

14. Dispositif selon l'une des revendications précédentes, caractérisé par le fait que le matériau à nombre de charges élevé a un nombre de charges au moins égal à 35.

15. Dispositif selon l'une des revendications précédentes, caractérisé par le fait que le matériau à nombre de charges élevé est du platine ou une céramique diélectrique choisie dans la famille des titanates, dans la famille des oxydes ou dans la famille des céramiques complexes à base de plomb.

## Ansprüche

1. Vorrichtung zum Härten eines elektronischen Bauteils (50) gegenüber Strahlungen, bestehend aus einer Vielzahl von Schichten (11 bis 15 ; 16 ; 17, 18 ; 46 bis 48), wobei die Anzahl von resultierenden Atomladungen der Vorrichtung über die Dicke variiert, dadurch gekennzeichnet, daß zumindest einzelne der Schichten mindestens zwei Materialien enthalten, wobei das eine eine bezüglich des anderen erhöhte Atomladungszahl besitzt, daß eines dieser Materialien in Form von Einlagen (10) vorliegt, die in die vom anderen Material gebildete Schicht eingebracht sind, und daß die Dichte von Einlagen, die innerhalb einer Schicht im wesentlichen konstant ist, von Schicht zu Schicht variiert.

2. Vorrichtung nach Anspruch 1, dadurch gekennzeichnet, daß die Schicht von einem Material mit niedriger Atomladungszahl gebildet wird und die Einlagen von einem Material mit hoher Atomladungszahl.

3. Vorrichtung nach einem der vorhergehenden Ansprüche, dadurch gekennzeichnet, daß die Einlagendichte derart variiert, daß die resultierende Ladungsanzahl ein Minimum auf der Seite des Bauteils besitzt.

4. Vorrichtung nach einem der vorhergehenden Ansprüche, dadurch gekennzeichnet, daß die Variation der Atomladungszahl symmetrisch bezüglich einer mittleren Zone der Vorrichtung ist.

5. Vorrichtung nach einem der vorhergehenden Ansprüche, dadurch gekennzeichnet, daß die Einlagen in der Schicht auf zufällige Weise angeordnet sind.

6. Vorrichtung nach Anspruch 5, dadurch gekennzeichnet, daß die Einlagen aus Kugeln oder Körnern bestehen.

7. Vorrichtung nach einem der Ansprüche 1 bis 4, dadurch gekennzeichnet, daß die Einlagen in der Schicht (16 ; 17 ; 18) in Löchern (19, 20) angeordnet sind, die in regelmäßigem Abstand in der Schicht vorgesehen sind.

8. Vorrichtung nach einem der vorhergehenden Ansprüche, dadurch gekennzeichnet, daß die Vorrichtung außerdem zwischen den Schichten (46 bis 48) leitende Schichten (41 bis 44) aufweist, die Elektroden bilden, wobei die Vorrichtung einen Kondensator darstellt.

9. Vorrichtung nach einem der vorhergehenden Ansprüche, dadurch gekennzeichnet, daß sie auf einer Seite des Bauteils angeordnet ist.

10. Vorrichtung nach einem der vorhergehenden Ansprüche, dadurch gekennzeichnet, daß sie mindestens einen Teil eines Gehäuses (62, 63) bildet, in das das Bauteil eingekapselt ist.

11. Vorrichtung nach einem der vorhergehenden Ansprüche, dadurch gekennzeichnet, daß sie auf einer Seite eines Gehäuses angeordnet ist, in das das Bauteil eingekapselt ist.

12. Vorrichtung nach einem der vorhergehenden Ansprüche, dadurch gekennzeichnet, daß das Material mit der niedrigen Ladungszahl eine Ladungszahl von mindestens gleich 20 aufweist.

13. Vorrichtung nach einem der vorhergehenden Ansprüche, dadurch gekennzeichnet, daß das Material mit der niedrigen Ladungszahl aus der Gruppe ausgewählt ist, die Kohlenstoff, Aluminium, Silizium, Aluminiumoxid und Siliziumoxid enthält.

14. Vorrichtung nach einem der vorhergehenden Ansprüche, dadurch gekennzeichnet, daß das Material mit der hohen Ladungszahl eine Ladungszahl von mindestens gleich 35 besitzt.

15. Vorrichtung nach einem der vorhergehenden Ansprüche, dadurch gekennzeichnet, daß das Material mit der hohen Ladungszahl Platin oder eine dielektrische Keramik ist, die aus der Familie der Titanate, der Familie der Oxide oder der Familie der komplexen Keramiken auf Bleibasis ausgewählt ist.

## Claims

1. A device for hardening an electronic component (50) against radiations, comprising a plurality of layers (11 to 15 ; 16 ; 17, 18 ; 46 to 48), the resulting number of atom charges of the device varying along its thickness, characterized in that at least certain ones of the layers comprise at least two materials, one having a high number of atom charges with respect to the other, that one of these materials is constituted by inserts (10) placed in the layer constituted by the other material, and that the insert density which is substantially constant within one layer, varies from one layer to the other.

2. A device according to claim 1, characterized in that the layer is constituted by a material of a low number of charges and the inserts of a material having a high number of charges.

3. A device according to one of the preceding claims, characterized in that the insert density varies in such a way that the resulting number of charges presents a minimum close to the component.

4. A device according to one of the preceding claims, characterized in that the variation in the number of charges is symmetrical with respect to the median zone of the device.

5. A device according to one of the preceding claims, characterized in that the inserts are disposed in the layer according to a random distribution.

6. A device according to claim 5, characterized in that the inserts are spheres or grains.

7. A device according to one of claims 1 to 4, characterized in that the inserts are disposed in the layer (16 ; 17 ; 18) in holes (19, 20) cut into the layer according to a regular distribution.

8. A device according to one of the preceding claims, characterized in that the device further comprises between the layers (46 to 48) conducting layers (41 to 44) which constitute electrodes, the device constituting a capacitor.

9. A device according to one of the preceding claims, characterized in that it is disposed on one surface of the component.

10. A device according to one of the preceding claims, characterized in that it constitutes at least a portion of a casing (62, 63) in which the component is encapsulated.

11. A device according to one of the preceding claims, characterized in that it is disposed on one surface of a casing in which the component is encapsulated.

12. A device according to one of the preceding claims, characterized in that the number of charges of the material having a low number of charges is at most equal to 20.

13. A device according to one of the preceding claims, characterized in that the material having a low number of charges is selected from the group consisting of carbon, aluminium, silicium, alumina and silica.

14. A device according to one of the preceding claims, characterized in that the number of charges of the material having a high number of charges is at least equal to 35.

15. A device according to one of the preceding claims, characterized in that the material having a high number of charges is platinum or a dielectric ceramic material selected among the family of titanates, the family of oxides or the family of complex lead-based ceramics.

# FIG_1

# FIG_2

# FIG_3

# FIG_4

# FIG_5

# FIG_6

# FIG_7